# EUROPEAN PATENT APPLICATION

(11) **EP 4 300 377 A1**
(43) Date of publication of application: **03.01.2024**
(21) Application number: 22779024.3
(22) Date of filing: 30.03.2022
(51) Int. Cl.: G06N 10/00, G06F 8/41

(54) **QUANTUM CIRCUIT COMPILATION METHOD AND DEVICE, COMPILATION FRAMEWORK AND QUANTUM OPERATING SYSTEM**

(30) Priority: 31.03.2021 CN 202110349907
(71) Applicant: Origin Quantum Computing Technology (Hefei) Co., Ltd, Hefei, Anhui 230088 (CN)
(72) Inventor: DOU, Menghan, Hefei, Anhui 230088 (CN); FANG, Yuan, Hefei, Anhui 230088 (CN); ZHAO, Dongyi, Hefei, Anhui 230088 (CN)
(74) Representative: Rau, Schneck & Hübner Patentanwälte Rechtsanwälte PartGmbB
(86) International application number: PCT/CN2022/084083
(87) International publication number: WO 2022/206842

(57) **Abstract**

Disclosed are a quantum circuit compilation method, a device, a compilation framework and a quantum operating system. The method determines a topological structure of a target quantum chip and a supportable logic gate set according to a configuration file in the compilation instruction; invoking the circuit processing module to process a to-be-complied circuit so as to generate a first supportable circuit; invoking the topological mapping module to map the first supportable circuit to a first operable circuit according to the topology structure; or invoking the topological mapping module to map the to-be-complied circuit to a second operable circuit; and invoking the circuit processing module to process the second operable circuit so as to generate a second supportable circuit. The disclosed embodiments may improve the development efficiency of quantum compilers. (FIG. 2)

## Description

### CROSS-REFERENCES TO RELATED APPLICATIONS

The disclosure claims priority to a Chinese patent application No. CN202110349907.9 filed on March 31, 2021 and entitled "QUANTUM CIRCUIT COMPILATION METHOD, DEVICE, COMPILATION FRAMEWORK AND QUANTUM OPERATING SYSTEM", which is hereby incorporated by reference in its entirety.

### TECHNICAL FIELD

The present disclosure relates to the field of quantum computation, in particular to a quantum circuit compilation method, a device, a compilation framework and a quantum operating system.

### BACKGROUND

Quantum computers are a class of physical devices that follow the laws of quantum mechanics to perform high-speed mathematical and logical operations, store and process quantum information. A device is a quantum computer when it processes and computes quantum information and runs quantum algorithms. Quantum computers become a key technology being researched because of their ability to handle mathematical problems more efficiently than ordinary computers, for example, to accelerate time cost for cracking RSA keys from hundreds of years to a few hours.

An instruction set of a quantum chip is a set of quantum operations supported by the quantum chip, and specifically contains a set of supported qubit logic gates and connection information of qubits on the quantum chip. Since different quantum chips correspond to different instruction sets, it is necessary to write different quantum compilation programs for different quantum chips respectively so that the same quantum circuit can operate on the different quantum chips, resulting in repetitive work and inefficient development.

### SUMMARY

An objective of the present disclosure is to provide a quantum circuit compilation method, a device, a compilation framework and a quantum operating system.

One embodiment of the present disclosure is directed to a situation where development inefficiencies result from the need to write different quantum compilation programs for different quantum chips.

One embodiment of the present disclosure provides a quantum circuit compilation method, and the method applies to a compilation framework comprising a circuit processing module and a topological mapping module, and comprises: determining, upon receiving a compilation instruction, a topological structure of a target quantum chip and a supportable logic gate set supported by the target quantum chip according to a configuration file in the compilation instruction; invoking the circuit processing module to process a to-be-complied circuit so as to generate a first supportable circuit, wherein logic gates in the first supportable circuit all belong to the supportable logic gate set, and invoking the topological mapping module to map the first supportable circuit to a first operable circuit according to the topology structure, wherein the first operable circuit is a quantum circuit that can operate on the target quantum chip; or invoking the topological mapping module to map the to-be-complied circuit to a second operable circuit according to the topology structure, wherein the second operable circuit is a quantum circuit that can operate on the target quantum chip; and invoking the circuit processing module to process the second operable circuit so as to generate a second supportable circuit, wherein logic gates in the second supportable circuit all belong to the supportable logic gate set.

Optionally, the circuit processing module comprises a logic gate processing unit, and said "invoking the circuit processing module to process a to-be-complied circuit" comprises: obtaining a logic gate in the to-be-complied circuit or the second operable circuit as a to-be-processed logic gate, and judging whether the to-be-processed logic gate belongs to the supportable logic gate set; and invoking the logic gate processing unit to convert the to-be-processed logic gate to a supportable logic gate if the to-be-processed logic gate does not belong to the supportable logic gate set.

Optionally, the logic gate processing unit comprises a decomposing subunit and a converting subunit, and said "invoking the logic gate processing unit to convert the to-be-processed logic gate to a supportable logic gate" comprises: when the to-be-processed logic gate is a basic logic gate, invoking the converting subunit to convert the to-be processed logic gate to a supportable logic gate according to a conversion rule in the configuration file; and when the to-be-processed logic gate is a multi-control logic gate, invoking the decomposing subunit to decompose the to-be-processed logic gate to a basic logic gate combination according to a decomposing rule in the configuration file, and invoking the converting subunit to convert every logic gate in the basic logic gate combination to a supportable logic gate according to the conversion rule.

Optionally, the circuit processing module further comprises a circuit optimizing unit, and said "invoking the circuit processing module to process the to-be-complied circuit or the second operable circuit" further comprises: determining a to-be-optimized logic gate in the to-be-complied circuit or the second operable circuit according to an optimization condition in the configuration file; and invoking the circuit optimizing unit to perform logic gate elimination and/or logic gate merging on the to-be-optimized logic gate according to an optimization rule in the configuration file.

Optionally, the compilation framework further comprises a circuit equivalence-verifying module, and the method further comprises: invoking the circuit equivalence-verifying module to judge whether the first supportable circuit and/or the second supportable circuit is/are equivalent to the to-be-complied circuit, and/or to judge whether the first operable circuit and/or the second operable circuit is/are equivalent to the to-be-complied circuit; and generating a warning message of circuit compilation exception when the first supportable circuit and/or the second supportable circuit and/or the first operable circuit and/or the second operable circuit is/are not equivalent to the to-be-complied circuit.

Optionally, said "invoking the topological mapping module to map the first supportable circuit to a first operable circuit according to the topology structure" comprises: obtaining a logic gate in the first supportable circuit as a target logic gate, and judging whether target operation bits of the target logic gate are adjacent on the target quantum chip according to the topological structure; and if the target operation bits are not adjacent on the target quantum chip, invoking the topological mapping module to swap the target operating bits to neighboring bits so as to map the first supportable circuit to the first operable circuit.

Another embodiment of the present disclosure provides a quantum circuit compilation device, and the device applies to a compilation framework comprising a circuit processing module and a topological mapping module, and comprises: a circuit configuration module configured for determining, upon receiving a compilation instruction, a topological structure of a target quantum chip, and a supportable logic gate set supported by the target quantum chip, according to a configuration file in the compilation instruction; a circuit processing module configured for processing a to-be-complied circuit so as to generate a first supportable circuit, or processing a second operable circuit so as to generate a second supportable circuit, wherein logic gates in the first supportable circuit and the second supportable circuit all belong to the supportable logic gate set; and a circuit mapping module configured for, according to the topology structure, mapping the first supportable circuit to a first operable circuit, or mapping the to-be-complied circuit to a second operable circuit, wherein the first operable circuit and the second operable circuit are quantum circuits that can operate on the target quantum chip.

Yet another embodiment of the present disclosure provides a storage medium, and the storage medium stores a computer program therein, wherein the computer program is configured for executing at runtime the method described in any one of the foregoing.

Yet another embodiment of the present disclosure provides an electronic device comprising a memory and a processor, the memory stores a computer program therein, and the processor is configured for running the computer program to execute the method described in any one of the foregoing.

Yet another embodiment of the present disclosure provides a quantum circuit compilation framework comprising a circuit processing module and a topological mapping module; wherein the circuit processing module is configured for, according to a supportable logic gate set supported by a target quantum chip, processing a to-be-complied circuit so as to generate a first supportable circuit, or processing a second operable circuit so as to generate a second supportable circuit, wherein logic gates in the first supportable circuit and the second supportable circuit all belong to the supportable logic gate set; and the topological mapping module is configured for, according to a topology structure of the target quantum chip, mapping the first supportable circuit to a first operable circuit, or mapping the to-be-complied circuit to a second operable circuit, wherein the first operable circuit and the second operable circuit are quantum circuits that can operate on the target quantum chip.

Yet another embodiment of the present disclosure provides a quantum operating system comprising the described quantum circuit compilation framework or the quantum circuit compilation method described in any one of the foregoing for compiling the to-be-complied circuit.

Compared to prior art, in the quantum circuit compilation method provided in the present disclosure, the quantum circuit compilation method applies to a compilation framework comprising a circuit processing module and a topological mapping module, and comprises: determining, upon receiving a compilation instruction, a topological structure of a target quantum chip and a supportable logic gate set supported by the target quantum chip according to a configuration file in the compilation instruction; invoking the circuit processing module to process a to-be-complied circuit so as to generate a first supportable circuit, wherein logic gates in the first supportable circuit all belong to the supportable logic gate set, and invoking the topological mapping module to map the first supportable circuit to a first operable circuit according to the topology structure, wherein the first operable circuit is a quantum circuit that can operate on the target quantum chip; or invoking the topological mapping module to map the to-be-complied circuit to a second operable circuit according to the topology structure, wherein the second operable circuit is a quantum circuit that can operate on the target quantum chip; and invoking the circuit processing module to process the second operable circuit so as to generate a second supportable circuit, wherein logic gates in the second supportable circuit all belong to the supportable logic gate set. In this way, the present disclosure provides common modules such as the circuit processing module and the topological mapping module for a quantum compiler developer based on the compilation framework, and then implements custom configurations of different quantum chips and/or different quantum circuits based on configuration files. This not only improves the development efficiency of quantum compilers, but also achieves the technical effect of adapting quantum circuits to arbitrary quantum chip instruction sets.

### BRIEF DESCRIPTION OF THE DRAWINGS

FIG. 1 is a structural block diagram of hardware of a computer terminal based on a quantum circuit compilation method provided by an embodiment of the present disclosure;
FIG. 2 is a schematic flow chart of a quantum circuit compilation method provided by an embodiment of the present disclosure;
FIG. 3 is a schematic flow chart of a quantum circuit compilation method provided by another embodiment of the present disclosure;
FIG. 4 is a schematic diagram of equivalent circuits provided by an embodiment of the present disclosure;
FIG. 5 is a schematic diagram of a quantum circuit compilation framework provided by an embodiment of the present disclosure.

### DETAILED DESCRIPTION

The embodiments described below with reference to the accompanying drawings are exemplary and are intended only to explain the invention and are not to be construed as limiting thereto.

An embodiment of the present disclosure provides a quantum circuit compilation method, which can be applied to an electronic device, such as a computer terminal, specifically, an ordinary computer, a quantum computer, etc.

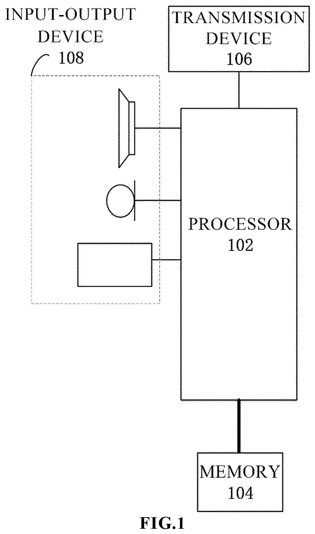

It will be described in detail below by taking running on a computer terminal as an example. FIG. 1 is a structural block diagram of hardware of a computer terminal of a quantum circuit compilation method provided by an embodiment of the present disclosure. As shown in FIG. 1, the computer terminal may include one or more (only one is shown in FIG. 1) processors 102 (the processors 102 may include, but are not limited to, a processing device such as a microprocessor MCU or a programmable logic device FPGA) and a memory 104 for storing an option estimation method based on quantum circuit. Optionally, the above computer terminal may further include a transmission device 106 and an input-output device 108 for a communication function. Those skilled in the art can understand that the structure shown in FIG. 1 is only schematic, and does not limit the structure of the computer terminal. For example, the computer terminal may also include more or fewer components than shown in FIG. 1, or have a different configuration than shown in FIG. 1.

The memory 104 may be used to store a software program as well as a module for application software, such as program instructions/modules corresponding to the implementation method of quantum convolution operation in embodiments of the present disclosure. The processor 102 executes various functional applications as well as data processing, i.e., implements the above-described method, by running the software program as well as the module stored in the memory 104. The memory 104 may include a high-speed random memory, and may also include a non-volatile memory, such as one or more magnetic storage devices, flash memory, or other non-volatile solid-state memory. In some examples, the memory 104 may further include memories set remotely relative to the processor 102, and these remote memories may be connected to the computer terminal via a network. An example of the network includes, but is not limited to, the Internet, an enterprise intranet, a local area network, a mobile communication network, and combinations thereof.

The transmission device 106 is used to receive or send data via a network. A specific example of the above network may include a wireless network provided by a communications provider of a computer terminal. In one example, the transmission device 106 includes a Network Interface Controller (NIC) that may be connected to other network devices via a base station so that it may communicate with the Internet. In one example, the transmission device 106 may be a Radio Frequency (RF) module for communicating wirelessly with the Internet.

It should be noted that a real quantum computer is hybrid in structure and consists of two main parts: a classical computer, which is responsible for performing classical computation and control, and a quantum device, which is responsible for running a quantum program and thus realizing quantum computation. The quantum program is a sequence of instructions written in a quantum language, such as Qrunes, that can be run on the quantum computer, which enables support for a quantum logic gate operation and ultimately quantum computation. Specifically, the quantum program is a sequence of instructions that operates the quantum logic gate in a certain time sequence.

In practical applications, due to limited development of hardware of quantum devices, quantum computing simulations are often required to verify quantum algorithms, quantum applications, and so on. Quantum computing simulation refers to the process of using the virtual architecture (that is, quantum virtual machine) built with the resources of ordinary computers to realize the simulation operation of quantum programs corresponding to specific problems. Often, it is necessary to construct quantum programs corresponding to specific problems. The quantum program referred to in the embodiment of the present disclosure is a program written in a classical language characterizing qubits and their evolution, wherein qubits, quantum logic gates, etc. related to quantum computing are represented by corresponding classical codes.

The quantum circuit, as an embodiment of a quantum program, is also known as a quantum logic circuit, is the most commonly used general-purpose quantum computation model, represents a circuit that operates on a qubit in an abstract concept, consists of a qubit, a circuit (a timeline), and a variety of quantum logic gates, and is often required to read out the results of the final quantum measurement operation.

Unlike a conventional circuit where metal wires are connected to transmit a voltage or current signal, in the quantum circuit, the circuit can be viewed as connected by time, i.e., the state of the qubit evolves naturally over time following the instructions of the Hamiltonian operator, until it encounters a logic gate and is operated.

A quantum program as a whole corresponds to an overall quantum circuit. The quantum program in this disclosure refers to the overall quantum circuit, wherein the total number of qubits in the overall quantum circuit is identical to the total number of qubits in the quantum program. It can be understood that a quantum program can be composed of a quantum circuit, measurement operations for the qubits in the quantum circuit, registers for storing the measured results, and control flow nodes (jump instructions). A quantum circuit can contain tens, hundreds or even thousands of quantum logic gate operations. The process of executing a quantum program is the process of executing all quantum logic gates according to a certain time sequence. It should be noted that a time sequence here refers to the time sequence in which a single quantum logic gate is executed.

It should be noted that in classical computing, the most basic unit is a bit, and the most basic control mode is a logic gate; as such, the purpose of controlling the circuit can be achieved through combination of logic gates. Similarly, the way to handle qubits is quantum logic gates. Using quantum logic gates may cause quantum states to evolve. Quantum logic gates are the basis of quantum circuits, and quantum logic gates include single-bit quantum logic gates, such as Hadamard gates (H gates, Hadamard gates), Pauli-X gates (X gates), Pauli-Y gates (Y gates) , Pauli-Z gates (Z gates), RX gates, RY gates, RZ gates, etc.; and multi-bit quantum logic gates, such as CNOT gates, CR gates, iSWAP gates, Toffoli gates, etc. Quantum logic gates are generally expressed by unitary matrices, where a unitary matrix is not only a form of matrix, but also a kind of operation and transformation. Generally, the function of a quantum logic gate on a quantum state is to compute with the unitary matrix left-multiplied by the matrix corresponding to the right vector of the quantum state.

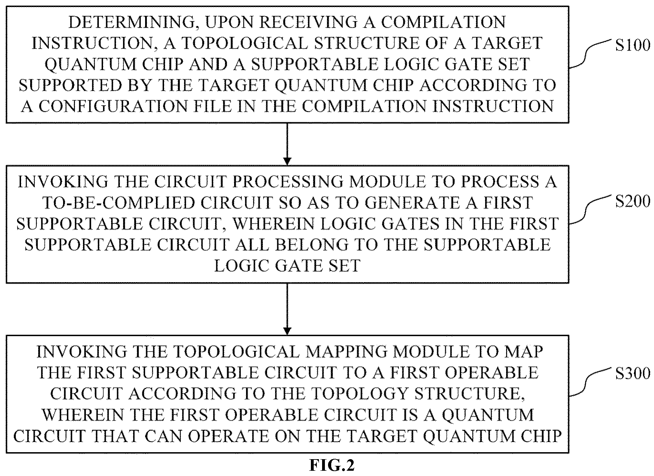

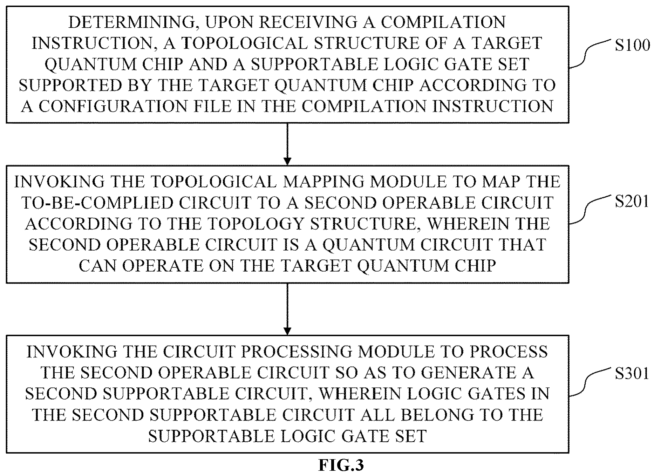

FIGS. 2 and 3 are referred to in the following to illustrate embodiments disclosed herein. FIG. 2 is a schematic flow chart of a quantum circuit compilation method provided by an embodiment of the present disclosure. FIG. 3 is a schematic flow chart of a quantum circuit compilation method provided by another embodiment of the present disclosure.

The present embodiment provides an embodiment of the quantum circuit compilation method, and the quantum circuit compilation method applies to a compilation framework comprising a circuit processing module and a topological mapping module circuit. The method may comprise the following steps S100, S200 and S300, or S100, S201 and S301.

Step S 100, determining, upon receiving a compilation instruction, a topological structure of a target quantum chip and a supportable logic gate set supported by the target quantum chip according to a configuration file in the compilation instruction.

For dealing with the technical problem that development inefficiencies result from the need to write different quantum compilation programs for different quantum chips, the present embodiment provides common modules such as the circuit processing module and the topological mapping module for a quantum compiler developer based on the compilation framework, and implements custom configurations of different quantum chips and/or different quantum circuits based on configuration files. Specifically, it is possible to perform abstraction and encapsulation on each functional module according to compiled historical compilation programs, and provide a corresponding interface for each functional module, so as to facilitate subsequent invoking of each functional module. Specific parameters involved in each functional module can be customized through configuration files uploaded by a user. In a specific embodiment, the user may set relevant parameters through a setting interface provided by a compilation framework, and the compilation framework generates configuration files according to the relevant parameters input by the user. In further embodiments, the user may also directly upload user-defined configuration files, and the compilation framework parses the configuration information in the configuration files through keywords in the configuration files. The compilation framework determines relevant information of the a to-be-operated target quantum chip of the to-be-complied circuit according to the user-defined configuration files, and the relevant information specifically includes the topological structure and the supportable logic gate set of the target quantum chip. Wherein, the topological structure is used to represent the entanglement relationship between the qubits supported by the target quantum chip (double quantum logic gates and multiple quantum logic gates can only be applied between neighboring bits on the target quantum chip); the supportable logic gate set includes various logic gates supported on the target quantum chip. Further, if a logic gate belongs to the supportable logic gate set, and the operation bits corresponding to the logic gate (double gate or multiple gates) are adjacently provided on the target quantum chip, then the logic gate can run on the target quantum chip.

As an implementation, the storage process of the topological structure is specified as follows:
Firstly obtaining a topological structure diagram of the target quantum chip, then constructing an adjacency matrix corresponding to the target quantum chip according to the topological structure diagram, and finally storing the adjacency matrix into the configuration files, so as to complete the configuration of the topological structure of the target quantum chip in the configuration files.

Step S200, invoking the circuit processing module to process a to-be-complied circuit so as to generate a first supportable circuit, wherein logic gates in the first supportable circuit all belong to the supportable logic gate set.

In the present embodiment, after the supportable logic gate set of the target quantum chip is determined, comparing each logic gate in the to-complied circuit with the supportable logic gate in the supportable logic gate set, and invoking a circuit processing module in the compilation framework to process the current to-be-complied circuit, so as to convert all the logic gates in the to-complied circuit into the supportable logic gate, and use the processed to-complied circuit as a first supportable circuit.

Although FIG. 2 illustrates that generation of a supportable circuit (first supportable circuit) is before generation of an operable circuit (first operable circuit); however, in light of the disclosure herein, one skilled in the art will appreciate that generation of an operable circuit (second operable circuit) may be before generation of a supportable circuit (second supportable circuit). The two ways are equivalent. Therefore, herein, step S201 in FIG. 3 may be executed first. That is, in the step 201, the topological mapping module is invoked to map the to-be-complied circuit to a second operable circuit according to the topology structure, wherein the second operable circuit is a quantum circuit that can operate on the target quantum chip. It should be understood by those skilled in the art that "first" and "second" herein are not intended to limit subsequent terms, and are merely intended to distinguish different terms. For example, the first supportable circuit and the second supportable circuit may be processed in the same way or in different ways in the same or different components; and the first operable circuit and the second operable circuit may also be processed in the same way or in different ways in the same or different components.

As an example, the circuit processing module specifically comprises a logic gate processing unit, and said "invoking the circuit processing module to process a to-be-complied circuit" comprises:
obtaining a logic gate in the to-be-complied circuit or the second operable circuit as a to-be-processed logic gate, and judging whether the to-be-processed logic gate belongs to the supportable logic gate set; and
invoking the logic gate processing unit to convert the to-be-processed logic gate to a supportable logic gate if the to-be-processed logic gate does not belong to the supportable logic gate set.

Since differences exist between logic gates supported by different quantum chips, when a quantum program corresponding to the same quantum circuit operates on different quantum chips, specific logic gates(i.e., logic gates not supported by the target quantum chip) in the quantum program need to be converted so that the quantum program can operate on the target quantum chip. Specifically, obtaining a logic gate in the to-be-complied circuit or the second operable circuit as a to-be-processed logic gate, and comparing the to-be-processed logic gate with the supportable logic gate to judge whether the to-be-processed logic gate belongs to the supportable logic gate set. If the to-be processed logic gate does not belong to the supportable logic gate set, that is, the to-be processed logic gate is not the supportable logic gate, then according to the conversion rule in the configuration files, invoking the logic gate processing unit to convert the to-be processed logic gate to the supportable logic gate. Then, return to obtain the next logic gate in the to-be-complied circuit or the second operable circuit as the to-be-processed logic gate, and repeating the above converting operation until all logic gates in the to-be-complied circuit or the second operable circuit have been converted to the supportable logic gates. Wherein, the conversion rule may be a logic gate conversion list or a logic gate conversion database.

As an example, the logic gate processing unit specifically comprises a decomposing subunit and a converting subunit, wherein the specific procedure of said "invoking the logic gate processing unit to convert the to-be-processed logic gate to a supportable logic gate" is:
when the to-be-processed logic gate is a basic logic gate, that is, the to-be-processed logic gate does not need to be decomposed, invoke the converting subunit to convert the to-be processed logic gate to the supportable logic gate according to a conversion rule in the configuration file.

When the to-be-processed logic gate is a multi-control logic gate, firstly decompose the to-be-processed logic gate and then convert the decomposed logic gate, that is, invoke the decomposing subunit to decompose the to-be-processed logic gate to a basic logic gate combination according to a decomposing rule in the configuration file, and invoke the converting subunit to convert every logic gate in the basic logic gate combination to the supportable logic gate according to the conversion rule. Wherein the decomposing rule is to decompose the multi-control gate into a plurality of basic logic gates according to the logic gate equivalence list in the configuration files.

As an example, the circuit processing module further comprises a circuit optimizing unit, and said "invoking the circuit processing module to process the to-be-complied circuit or the second operable circuit" further comprises:
determining a to-be-optimized logic gate in the to-be-complied circuit or the second operable circuit according to an optimization condition in the configuration file; and
invoking the circuit optimizing unit to perform logic gate elimination and/or logic gate merging on the to-be-optimized logic gate according to an optimization rule in the configuration file.

To improve the conversion efficiency of the logic gates, before converting each logic gate in the to-be-complied circuit or the second operable circuit to the supportable logic gate, or after converting each logic gate in the to-be-complied circuit or the second operable circuit to the supportable logic gate, it is possible to perform operations such as logic gate merging or logic gate elimination on each logic gate in the to-complied circuit or the second operable circuit. Wherein, the logic gate elimination includes direct elimination and cancellation. Specifically, obtaining the optimization condition in the configuration files, wherein the optimization condition may specifically be that there are consecutive identical logic gates (two consecutive RZ gates), two adjacent logic gates are cancellable logic gates (for example, two consecutive Hadamard gates or two consecutive X gates), there is an identity matrix, or it is judged that there is an RZ gate at the end of the circuit. Upon detecting the presence of a to-be-optimized logic gate in the to-be-complied circuit or the second operable circuit that meets the optimization condition, the circuit optimization unit may be invoked according to the optimization rule in order to perform operations such as logic gate elimination and/or logic gate merging on the to-be-optimized logic gates in the to-be-complied circuit or the second operable circuit that meets the optimization condition. Wherein, if the to-be-optimized logic gate is two consecutive RZ gates, the optimization rule may be that merging two consecutive RZ gates into one RZ gate, and a rotation angle of the newly merged RZ gate is a sum of the angles of the two RZ gates before merging; in a specific embodiment, for mergeable logic gates, multiple consecutive logic gates (not limited to two consecutive logic gates) may be merged; if the to-be-optimized logic gate is two consecutive Hadamard gates or two consecutive X gates (whose role is equivalent to that of an idle gate (I-gate)), and without considering noise, the optimization rule may be that two consecutive Hadamard gates or two consecutive X-gate gates cancel each other out (cancel); if the to-be-optimized logic gate is the identity matrix or the RZ gate at the end of the circuit, the optimization rule may be that the identity matrix and the RZ gate at the end of the circuit are directly eliminated (direct-elimination).

Further, said "invoking the circuit processing module to process the to-be-complied circuit" further comprises:
according to a circuit replacement rule in the configuration files, invoking the circuit optimizing unit to replace one sub-circuit of the to-be-complied circuit or the second operable circuit.

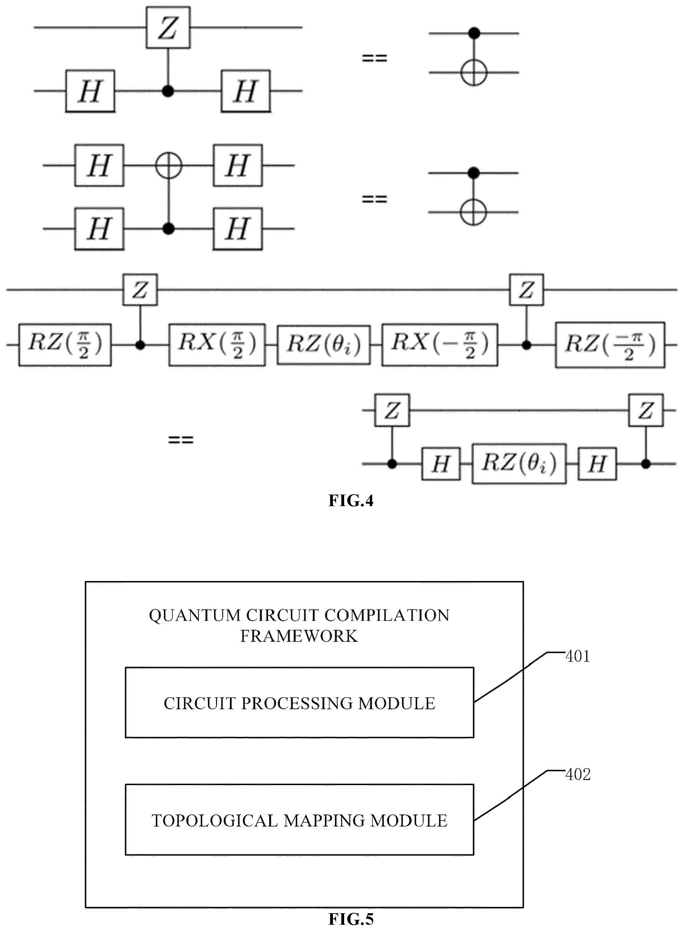

Specifically, as shown in FIG. 4, it shows three pairs of equivalent circuits, wherein the sub-circuit on the right side of the equation is more concise than the sub-circuit on the left side of the equation. When the circuit replacement rule is to simplify circuits (for example, to reduce the quantity of logic gates in the circuit), the circuits on the left side of the equation can be replaced with the circuits on the right side of the equation, thus simplifying the quantum circuit and improving the operational efficiency of the quantum circuit; if only the base logic gates shown on the left side of the equation are supported on the quantum chip, it is necessary to replace the circuits on the right side of the equation with the quantum circuits on the left side of the equation. In the specific embodiment, the user can customize the circuit replacement rule through the configuration files according to actual needs.

It is to be noted that when replacing a local circuit in the to-be-optimized circuit, in order to avoid a problem that the to-be-optimized circuit is too long to cause inefficiencies in finding the local circuit, it is possible to segment the to-be-optimized circuit when the to-be-optimized circuit exceeds a predetermined length and perform parallel lookups in multiple to-be-optimized sub-circuits after segmentation to quickly identify the local circuit to be replaced. When segmenting the to-be-optimized circuit, in order to prevent the local circuit to be replaced from being segmented and therefore not being found in the to-be-optimized sub-circuit after segmentation, a portion of overlapping circuits between adjacent to-be-optimized sub-circuits is retained when segmenting the to-be-optimized circuit, and the length of the overlapping circuits exceeds the length of the local circuit to be replaced, therefore ensuring the integrity of the local circuit to be replaced and avoiding the problem of failure of segmented parallel optimization algorithm due to segmentation of the local circuit to be replaced.

Step S300, invoking the topological mapping module to map the first supportable circuit to a first operable circuit according to the topology structure, wherein the first operable circuit is a quantum circuit that can operate on the target quantum chip.

Based on what is disclosed herein, those skilled in the art should understand that the supportable circuit may also be generated by the operable circuit. Thus, herein, a step S301 in FIG. 3 may also be performed. That is, in the Step S301, invoking the circuit processing module to process the second operable circuit so as to generate a second supportable circuit, wherein logic gates in the second supportable circuit all belong to the supportable logic gate set.

In the present embodiment, after converting the to-be-complied circuit to the first supportable circuit, according to the topological structure of the target quantum chip, further judging whether each logic gate in the first supportable circuit can operate directly on the quantum chip, specifically comprises:
obtaining a logic gate in the first supportable circuit as a target logic gate, and judging whether target operation bits of the target logic gate are adjacent on the target quantum chip according to the topological structure; when the target operation bits are adjacent on the target quantum chip, it indicates that the target logic gates may be applied directly on the target operation bits on the target quantum chip.

If the target operation bits are not adjacent on the target quantum chip, then invoke the topological mapping module to swap the target operational bits into neighboring bits. Then, re-obtain a next logic gate in the first supportable circuit as a target logic gate, and repeat the conversion operation until the first supportable circuit is mapped into the first operable circuit, wherein two or more operation bits corresponding to each logic gate in the first operable circuit are neighboring bits on the target quantum chip.

It should be noted that the target logic gate in the present embodiment is a two-bit quantum logic gate, and it can be judged whether the two bits (i.e., target operation bits) to be acted on by the target logic gate are adjacent according to the topological structure.

Further, when invoking the topological mapping module to map the first supportable circuit to the first operable circuit, that is, when introducing SWAP logic gates by topological mapping, SWAP logic gates are applied between two qubits that are not adjacent to each other to enable swapping of qubits. There are multiple shortest paths between two nonadjacent qubits, via which two nonadjacent qubits can be swapped with adjacent bits. Wherein, the fidelity of each shortest path varies, and in order to improve the execution accuracy of the quantum circuit, in the present embodiment, the shortest path with the highest fidelity is preferred (i.e., the product of the fidelity of the individual logic gates in the shortest path is highest).

It should be understood by those skilled in the art that, in the same way, the to-be-complied circuit may be converted into a second operable circuit.

Further, the compilation framework further comprises a circuit equivalence-verifying module, and the method further comprises:
invoking the circuit equivalence-verifying module to judge whether the first supportable circuit and/or the second supportable circuit is/are equivalent to the to-be-complied circuit, and/or to judge whether the first operable circuit and/or the second operable circuit is/are equivalent to the to-be-complied circuit; and
generating a warning message of circuit compilation exception when the first supportable circuit and/or the second supportable circuit and/or the first operable circuit and/or the second operable circuit is/are not equivalent to the to-be-complied circuit.

In the present embodiment, after converting the to-be-complied circuit into the first supportable circuit and/or the second supportable circuit or the second operable circuit and/or the second operable circuit, in order to prevent functional changes in the converted circuit, the compilation framework further provides the circuit equivalence-verifying module, and the user may invoke the equivalence-verifying module to verify the converted circuit through a verifying interface corresponding to the circuit equivalence-verifying module. Wherein, specifically, this can be done by measuring whether the circuit matrix has changed, and if the circuit matrix remains unchanged, it means that the circuit function does not change. If the first supportable circuit and/or the second supportable circuit and/or the first operable circuit and/or the second operable circuit are not equivalent to the to-be-complied circuit, it means that an error has occurred in the conversion process, resulting in incorrect circuit output which can be alerted to the user by generating a warning message for circuit compilation exceptions; on the other hand, if the first supportable circuit and/or the second supportable circuit and/or the first operable circuit and/or the second operable circuit are equivalent to the to-be-complied circuit, it means that the functionality of the converted quantum program is unchanged while the circuit is converted successfully.

Compared to prior art, in the quantum circuit compilation method provided by the present embodiment, the method applies to a compilation framework comprising a circuit processing module and a topological mapping module, and comprises: determining, upon receiving a compilation instruction, a topological structure of a target quantum chip and a supportable logic gate set supported by the target quantum chip according to a configuration file in the compilation instruction; invoking the circuit processing module to process a to-be-complied circuit so as to generate a first supportable circuit, wherein logic gates in the first supportable circuit all belong to the supportable logic gate set, and invoking the topological mapping module to map the first supportable circuit to a first operable circuit according to the topology structure, wherein the first operable circuit is a quantum circuit that can operate on the target quantum chip; or invoking the topological mapping module to map the to-be-complied circuit to a second operable circuit according to the topology structure, wherein the second operable circuit is a quantum circuit that can operate on the target quantum chip; and invoking the circuit processing module to process the second operable circuit so as to generate a second supportable circuit, wherein logic gates in the second supportable circuit all belong to the supportable logic gate set. In this way, the present embodiment provides common modules such as the circuit processing module and the topological mapping module for a quantum compiler developer based on the compilation framework, and then implements custom configurations of different quantum chips and/or different quantum circuits based on configuration files. This not only improves the development efficiency of quantum compilers, but also achieves the technical effect of adapting quantum circuits to arbitrary quantum chip instruction sets.

Another embodiment of the present disclosure provides a quantum circuit compilation device, which applies to a compilation framework comprising a circuit processing module and a topological mapping module, and the device comprises:
a configuration file parsing module, configured for determining, upon receiving a compilation instruction, a topological structure of a target quantum chip and a supportable logic gate set supported by the target quantum chip according to a configuration file in the compilation instruction;
a supportable circuit generating module, configured for invoking the circuit processing module to process a to-be-complied circuit so as to generate a first supportable circuit, or processing the second operable circuit to generate a second supportable circuit, wherein logic gates in the first supportable circuit and the second supportable circuit all belong to the supportable logic gate set; and
an operable circuit generating module, configured for invoking the topological mapping module to map the first supportable circuit to a first operable circuit according to the topology structure, or mapping the to-be-complied circuit to the second operable circuit, wherein the first and second operable circuits are quantum circuits operable on the target quantum chip.

Further, the circuit processing module comprises a logic gate processing unit, and the supportable circuit generating module specifically comprises:
a to-be-processed logic gate judging unit, configured for obtaining a logic gate in the to-be-complied circuit or the second operable circuit as a to-be processed logic gate, and judging whether the to-be processed logic gate belongs to the supportable logic gate set; and
a to-be-processed logic gate processing unit, configured for invoking the logic gate processing unit to convert the to-be-processed logic gate to a supportable logic gate if the to-be-processed logic gate does not belong to the supportable logic gate set.

Further, the logic gate processing unit comprises a decomposing subunit and a converting subunit, and the to-be-processed logic gate processing unit specifically comprises:
a first processing subunit, configured for when the to-be-processed logic gate is a basic logic gate, invoking the converting subunit to convert the to-be processed logic gate to the supportable logic gate according to a conversion rule in the configuration file; and
a second processing subunit, configured for when the to-be-processed logic gate is a multi-control logic gate, invoking the decomposing subunit to decompose the to-be-processed logic gate to a basic logic gate combination according to a decomposing rule in the configuration file, and invoking the converting subunit to convert every logic gate in the basic logic gate combination to the supportable logic gate according to the conversion rule.

Further, the circuit processing module further comprises a circuit optimizing unit, and the supportable circuit generating module further specifically comprises:
a to-be-optimized logic gate determining unit, configured for determining a to-be-optimized logic gate in the to-be-complied circuit according to the optimization condition in the configuration files;
a to-be-optimized logic gate optimizing unit, configured for invoking the circuit optimizing unit to perform logic gate elimination and/or logic gate merging on the to-be-optimized logic gate according to an optimization rule in the configuration file.

Further, the compilation framework further comprises a circuit equivalence-verifying module, the device further comprises:
a circuit equivalence-judging module configured for invoking the circuit equivalence-verifying module to judge whether the first supportable circuit and/or the second supportable circuit is/are equivalent to the to-be-complied circuit, and/or to judge whether the first operable circuit and/or the second operable circuit is/are equivalent to the to-be-complied circuit; and
a converting exception warning module, configured for generating a warning message of circuit compilation exception when the first supportable circuit and/or the second supportable circuit and/or the first operable circuit and/or the second operable circuit is/are not equivalent to the to-be-complied circuit.

Further, the operable circuit generating module specifically comprises:
an operating bits judging unit, configured for obtaining a logic gate in the first supportable circuit or the to-be-complied circuit as a target logic gate, and judging whether target operation bits of the target logic gate are adjacent on the target quantum chip according to the topological structure;
an operating bits swapping unit, configured for if the target operation bits are not adjacent on the target quantum chip, invoking the topological mapping module to swap the target operating bits to neighboring bits so as to map the first supportable circuit to the first operable circuit or map the to-be-complied circuit to the second operable circuit.

Referring to FIG. 5, FIG 5 is a quantum circuit compilation framework schematic provided by embodiments of the present disclosure.

Yet another embodiment of the present disclosure provides a quantum circuit compilation framework, which comprises a circuit processing module 401 and a topological mapping module 402;
the circuit processing module 401 is configured for, according to a supportable logic gate set supported by a target quantum chip, processing a to-be-complied circuit so as to generate a first supportable circuit, or processing a second operable circuit so as to generate a second supportable circuit, wherein logic gates in the first supportable circuit and the second supportable circuit all belong to the supportable logic gate set; and
the topological mapping module 402 is configured for, according to a topology structure of the target quantum chip, mapping the first supportable circuit to a first operable circuit, or mapping the to-be-complied circuit to a second operable circuit, wherein the first operable circuit and the second operable circuit are quantum circuits that can operate on the target quantum chip.

Further, the circuit processing module 401 comprises a logic gate processing unit,
the logic gate processing unit is configured for converting the to-be-processed logic gate in the to-be-complied circuit or the second operable circuit that does not belong to the supportable logic gate set to a supportable logic gate.

Further, the logic gate processing unit comprises a decomposing subunit and a converting subunit,
the converting subunit is configured for converting the to-be-processed logic gate of the basic logic gate to the supportable logic gate according to a conversion rule;
the decomposing subunit is configured for decomposing the to-be-processed logic gate being the multi-control logic gate into the base logic gate combination according to a decomposing rule.

Further, the circuit processing module 401 further comprises a circuit optimizing unit,
the circuit optimizing unit is configured for performing logic gate elimination and/or logic gate merging on the to-be-optimized logic gate in the to-be-complied circuit that conforms to the optimization condition according to an optimization rule.

Further, the compilation framework further comprises a circuit equivalence-verifying module,
the circuit equivalence-verifying module is configured for generating a warning message of circuit compilation exception when the first supportable circuit and/or the second supportable circuit and/or the first operable circuit and/or the second operable circuit is/are not equivalent to the to-be-complied circuit.

Further, the topological mapping module 402 is further configured for swapping the operating bits corresponding to individual logic gates in the first supportable circuit to neighboring bits according to the topological structure, so as to map the first supportable circuit to the first operable circuit; or, swapping the operating bits corresponding to individual logic gates in the to-be-complied circuit to neighboring bits, so as to map the to-be-complied circuit to the second operable circuit.

Yet another embodiment of the present disclosure provides a storage medium which stores a computer program therein, wherein the computer program is configured for performing at runtime the steps of any one of the above method embodiments.

Specifically, in the present embodiment, the above storage medium may be set to store a computer program for performing the following steps:
S 1, determining, upon receiving a compilation instruction, a topological structure of a target quantum chip and a supportable logic gate set supported by the target quantum chip according to a configuration file in the compilation instruction.
S2, invoking the circuit processing module to process a to-be-complied circuit so as to generate a first supportable circuit, wherein logic gates in the first supportable circuit all belong to the supportable logic gate set; or, invoking the topological mapping module to map the to-be-complied circuit to a second operable circuit according to the topology structure, wherein the second operable circuit is a quantum circuit that can operate on the target quantum chip.
S3, invoking the topological mapping module to map the first supportable circuit to a first operable circuit according to the topology structure, wherein the first operable circuit is a quantum circuit that can operate on the target quantum chip; or, invoking the circuit processing module to process the second operable circuit so as to generate a second supportable circuit, wherein logic gates in the second supportable circuit all belong to the supportable logic gate set.

Specifically, in the present embodiment, the above storage media may include, but are not limited to: U disk, read-only memory (ROM), random access memory (RAM), portable hard disk, disk or optical disc and other media that can store computer programs.

Yet another embodiment of the present disclosure provides an electronic device comprising a memory and a processor, the memory is stored with a computer program therein, and the processor is set to run the computer program to execute the steps of any one of the above method embodiments.

Specifically, the above electronic device may further comprise a transmission device and an input-output device, wherein the transmission device is connected to the above processor, and the input-output device is connected to the above processor.

Specifically, in the present embodiment, the above processor may be set to perform the following steps by a computer program:
S 1, determining, upon receiving a compilation instruction, a topological structure of a target quantum chip and a supportable logic gate set supported by the target quantum chip according to a configuration file in the compilation instruction;
S2, invoking the circuit processing module to process a to-be-complied circuit so as to generate a first supportable circuit, wherein logic gates in the first supportable circuit all belong to the supportable logic gate set; or, invoking the topological mapping module to map the to-be-complied circuit to a second operable circuit according to the topology structure, wherein the second operable circuit is a quantum circuit that can operate on the target quantum chip.
S3, invoking the topological mapping module to map the first supportable circuit to a first operable circuit according to the topology structure, wherein the first operable circuit is a quantum circuit that can operate on the target quantum chip; or, invoking the circuit processing module to process the second operable circuit so as to generate a second supportable circuit, wherein logic gates in the second supportable circuit all belong to the supportable logic gate set.

Yet another embodiment of the present disclosure provides a quantum operating system, which comprises the quantum circuit compilation framework of the above embodiment (that is, a compilation framework) or compiles the to-be-complied circuit according to the quantum circuit compilation method of the above embodiment.

The above embodiments shown in accordance with the schemas detail the structure, characteristics, and effects of the present disclosure, and the above is only a preferred embodiment of the present disclosure, but the present disclosure does not limit the scope of embodiment as shown in the accompanying drawings. Any alteration made in accordance with the conception of the present disclosure, or modified to an equivalent embodiment of the change, shall be within the scope of protection of the present disclosure if it is not beyond the spirit covered by the description and accompanying drawings.

## Claims

1. A quantum circuit compilation method, **characterized in that** the method applies to a compilation framework comprising a circuit processing module and a topological mapping module, and comprises:
determining, upon receiving a compilation instruction, a topological structure of a target quantum chip and a supportable logic gate set supported by the target quantum chip according to a configuration file in the compilation instruction;
invoking the circuit processing module to process a to-be-complied circuit so as to generate a first supportable circuit, wherein logic gates in the first supportable circuit all belong to the supportable logic gate set, and
invoking the topological mapping module to map the first supportable circuit to a first operable circuit according to the topology structure, wherein the first operable circuit is a quantum circuit that can operate on the target quantum chip; or
invoking the topological mapping module to map the to-be-complied circuit to a second operable circuit according to the topology structure, wherein the second operable circuit is a quantum circuit that can operate on the target quantum chip; and
invoking the circuit processing module to process the second operable circuit so as to generate a second supportable circuit, wherein logic gates in the second supportable circuit all belong to the supportable logic gate set.

2. The quantum circuit compilation method of claim 1, **characterized in that** the circuit processing module comprises a logic gate processing unit, and said "invoking the circuit processing module to process a to-be-complied circuit" comprises:
obtaining a logic gate in the to-be-complied circuit or the second operable circuit as a to-be-processed logic gate, and judging whether the to-be-processed logic gate belongs to the supportable logic gate set; and
invoking the logic gate processing unit to convert the to-be-processed logic gate to a supportable logic gate if the to-be-processed logic gate does not belong to the supportable logic gate set.

3. The quantum circuit compilation method of claim 2, **characterized in that** the logic gate processing unit comprises a decomposing subunit and a converting subunit, and said "invoking the logic gate processing unit to convert the to-be-processed logic gate to a supportable logic gate" comprises:
when the to-be-processed logic gate is a basic logic gate, invoking the converting subunit to convert the to-be processed logic gate to a supportable logic gate according to a conversion rule in the configuration file; and
when the to-be-processed logic gate is a multi-control logic gate, invoking the decomposing subunit to decompose the to-be-processed logic gate to a basic logic gate combination according to a decomposing rule in the configuration file, and invoking the converting subunit to convert every logic gate in the basic logic gate combination to a supportable logic gate according to the conversion rule.

4. The quantum circuit compilation method of claim 1, **characterized in that** the circuit processing module further comprises a circuit optimizing unit, and said "invoking the circuit processing module to process the to-be-complied circuit or the second operable circuit" further comprises:
determining a to-be-optimized logic gate in the to-be-complied circuit or the second operable circuit according to an optimization condition in the configuration file; and
invoking the circuit optimizing unit to perform logic gate elimination and/or logic gate merging on the to-be-optimized logic gate according to an optimization rule in the configuration file.

5. The quantum circuit compilation method of claim 1, **characterized in that** the compilation framework further comprises a circuit equivalence-verifying module, and the method further comprises:
invoking the circuit equivalence-verifying module to judge whether the first supportable circuit and/or the second supportable circuit is/are equivalent to the to-be-complied circuit, and/or to judge whether the first operable circuit and/or the second operable circuit is/are equivalent to the to-be-complied circuit; and
generating a warning message of circuit compilation exception when the first supportable circuit and/or the second supportable circuit and/or the first operable circuit and/or the second operable circuit is/are not equivalent to the to-be-complied circuit.

6. The quantum circuit compilation method of any one of claims 1 to 5, **characterized in that** said "invoking the topological mapping module to map the first supportable circuit to a first operable circuit according to the topology structure" comprises:
obtaining a logic gate in the first supportable circuit as a target logic gate, and judging whether target operation bits of the target logic gate are adjacent on the target quantum chip according to the topological structure; and
if the target operation bits are not adjacent on the target quantum chip, invoking the topological mapping module to swap the target operating bits to neighboring bits so as to map the first supportable circuit to the first operable circuit.

7. A quantum circuit compilation device, **characterized in that** the device applies to a compilation framework comprising a circuit processing module and a topological mapping module, and the quantum circuit compilation device comprises:
a circuit configuration module configured for determining, upon receiving a compilation instruction, a topological structure of a target quantum chip, and a supportable logic gate set supported by the target quantum chip, according to a configuration file in the compilation instruction;
a circuit processing module configured for processing a to-be-complied circuit so as to generate a first supportable circuit, or processing a second operable circuit so as to generate a second supportable circuit, wherein logic gates in the first supportable circuit and the second supportable circuit all belong to the supportable logic gate set; and
a circuit mapping module configured for, according to the topology structure, mapping the first supportable circuit to a first operable circuit, or mapping the to-be-complied circuit to a second operable circuit, wherein the first operable circuit and the second operable circuit are quantum circuits that can operate on the target quantum chip.

8. A storage medium, **characterized in that** the storage medium stores a computer program therein, wherein the computer program is configured for executing at runtime the method of any one of claims 1 to 6.

9. An electronic device comprising a memory and a processor, **characterized in that** the memory stores a computer program therein, and the processor is configured for running the computer program to execute the method of any one of claims 1 to 6.

10. A quantum circuit compilation framework, **characterized by** comprising a circuit processing module and a topological mapping module; wherein
the circuit processing module is configured for, according to a supportable logic gate set supported by a target quantum chip, processing a to-be-complied circuit so as to generate a first supportable circuit, or processing a second operable circuit so as to generate a second supportable circuit, wherein logic gates in the first supportable circuit and the second supportable circuit all belong to the supportable logic gate set; and
the topological mapping module is configured for, according to a topology structure of the target quantum chip, mapping the first supportable circuit to a first operable circuit, or mapping the to-be-complied circuit to a second operable circuit, wherein the first operable circuit and the second operable circuit are quantum circuits that can operate on the target quantum chip.

11. A quantum operating system, **characterized by** comprising the quantum circuit compilation framework of claim 10 or the quantum circuit compilation method of any one of claims 1 to 6 for compiling the to-be-complied circuit.
